Europäisches Patentamt

European Patent Office

Office européen des brevets

(19)

(11) Numéro de publication : **0 455 551 A1**

(12) # DEMANDE DE BREVET EUROPEEN

(21) Numéro de dépôt : **91401129.1**

(22) Date de dépôt : **29.04.91**

(51) Int. Cl.⁵ : **C23C 16/30, C23C 16/02**

(30) Priorité : **02.05.90 FR 9005529**

(43) Date de publication de la demande :
**06.11.91 Bulletin 91/45**

(84) Etats contractants désignés :
**AT BE CH DE ES FR GB IT LI LU NL SE**

(71) Demandeur : **L'AIR LIQUIDE, SOCIETE ANONYME POUR L'ETUDE ET L'EXPLOITATION DES PROCEDES GEORGES CLAUDE
75, Quai d'Orsay
F-75321 Paris Cédex 07 (FR)**

(72) Inventeur : **Rostaing, Jean-Christophe
23 rue Ardy
F-78000 Versailles (FR)**
Inventeur : **Coeuret, François
63 boulevard Beethoven, Résidence les Symphonies
F-78280 Guyancourt (FR)**

(74) Mandataire : **Le Moenner, Gabriel et al
L'AIR LIQUIDE, Société Anonyme pour l'étude et l'exploitation des procédés Georges Claude
75, Quai d'Orsay
F-75321 Paris Cédex 07 (FR)**

(54) **Revêtement multicouche pour substrat polycarbonate et procédé d'élaboration d'un tel revêtement.**

(57)    Revêtement multicouche pour substrat polycarbonate utilisé à titre de succédané du verre, comportant essentiellement du silicium, du carbone, de l'azote, de l'oxygène et de l'hydrogène, caractérisé par une première couche anti-ultra-violet constituée de silicium, d'oxygène et/ou d'azote, de carbone et d'hydrogène, selon la formule :

$Si\ Cx_1\ Oz_1\ Ht_1$, où $x_1 + z_1 + t_1$ est compris entre 1,2 et 1,5
$Si\ Cx_1\ Ny_1\ Ht_1$, où $x_1 + y_1 + t_1$ est compris entre 1,2 et 1,5
$Si\ Cx_1\ Ny_1\ Oz_1\ Ht_1$, où $x_1 + y_1 + z_1 + t_1$ est compris entre 1,2 et 1,5

et dans tous les cas $t_1$ est compris entre 0,1 et 0,7 ; $x_1$ est faible devant $y_1$ et/ou $z_1$, de façon que le seuil d'absorption optique soit centré vers 350 nm ; la seconde couche transparente de dureté est constituée de silicium, d'oxygène, d'azote, de carbone et d'hydrogène, de formule $SiCx_2Ny_2Oz_2Ht_2$, avec en particulier :

— soit $y_2 = 0$, $z_2$ compris entre 1,7 et 2,0, $t_2$ compris entre 0,1 et 0,7, $x_2$ faible devant $z_2$ ;
— soit $y_2$ compris entre 1,0 et 1,3, $t_2$ compris entre 0,1 et 0,7, $x_2$ et $z_2$ sont faibles devant $y_2$ ;

L'invention s'applique à la protection du polycarbonate contre un vieillissement occasionné par le rayonnement ultra-violet, en particulier pour les glaces de phares automobiles, les verres de lunettes.

EP 0 455 551 A1

La présente invention concerne les revêtements multicouches pour substrat polycarbonate utilisé à titre de succédané du verre, pour la fabrication de glaces de phares d'automobiles, de verres de lunettes, etc... Le polycarbonate est cependant très sensible au rayonnement ultra-violet et, lorsqu'il est exposé à une lampe xénon haute pression (émission continue de 140 à plus de 400 nm), il jaunit, se fissure et subit un vieillissement très accéléré.

Pour les applications glaces de phares dans l'automobile, le polycarbonate est généralement recouvert d'un vernis dur protecteur composé de deux couches assurant chacune une fonction particulière :

    – une couche anti-ultra-violet dont le rôle est de bloquer, dans toute la mesure du possible, toutes les radiations de longueur d'onde inférieure à 350 nm ;

    – une couche dure protectrice.

On a déjà proposé dans le document FR-A-2.614.317 d'assurer ces dépôts protecteurs à partir de silicium et oxygène et/ou azote et/ou hydrogène à l'aide de précurseurs gazeux de ces éléments, tels un silane, $O_2$, $N_2O$, $N_2$, $NH_3$, en présence d'un plasma et, dans le document FR-A-2.631.346, de réaliser des couches de formule $SiC_xN_yO_zH_t$ où, pour la première couche, x est compris entre 0 et 0,5, y entre 0 et 0,15, z entre 0,4 et 1 et t entre 0,6 et 1,2, alors que, pour la seconde couche, x' est compris entre 0 et 5, y' entre 0,3 et 0,8, z' entre 1,3 et 2,5 et t' entre 0,5 et 1,2. Ces documents sont supposés intégrés ici pour référence.

Cependant, il s'est avéré que de tels revêtements, notamment le revêtement dur, peuvent se dégrader lorsqu'ils sont soumis au rayonnement d'une lampe xénon haute pression. Cette dégradation se traduit par un décollement des dépôts et un jaunissement du polycarbonate. On peut expliquer cette défectuosité par la dégradation du dépôt lui-même, et/ou la dégradation du polymère (amorces de fissures entraînant des contraintes dans le dépôt) et/ou une détérioration de l'interface (diminution de l'adhésion).

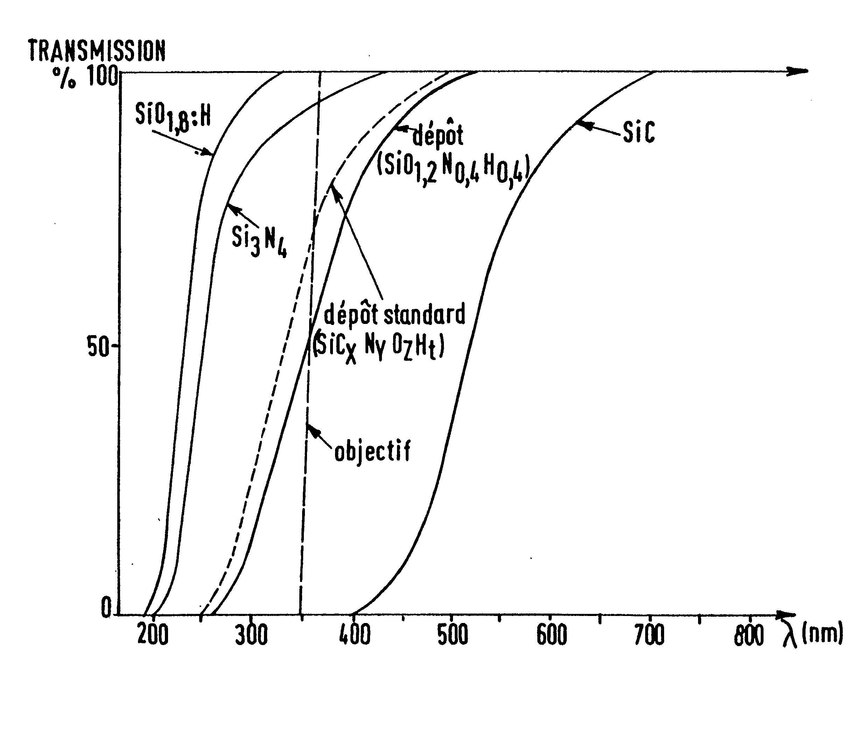

Les dépôts durs d'oxynitrures de silicium réalisés par plasma-CVD sans apport intentionnel de carbone ont une composition du type $SiC_xN_yO_zH_t$, où x est faible (le carbone provenant uniquement du substrat de polycarbonate ou de l'atmosphère) et contiennent peu de liaisons Si-Si. Ces alliages ont des propriétés optiques proches de celles d'un mélange physique $Si_3N_4$ / $SiO_2$ et en particulier laissent passer complètement le rayonnement ultra-violet en dessous de 350 nm, ainsi que le montre la courbe en pointillé à la figure annexée, où le coefficient de transmission T (pourcentage) est noté en ordonnée pour différentes longueurs d'ondes (nm) en abscisse.

La présente invention vise un revêtement de ce type réalisable par PECVD ("plasma enhanced chemical vapor deposition"), selon le procédé cité précédemment qui stoppe le rayonnement à longueur d'onde inférieure à 350 nm, et cela de façon nettement plus abrupte, comme indiqué par le trait interrompu repéré "objectif" sur la figure et cet objectif de l'invention est atteint par une première couche anti-ultra-violet constituée de silicium, d'oxygène et/ou d'azote, de carbone et d'hydrogène, selon la formule :

    $Si\ Cx_1\ Oz_1\ Ht_1$, ou

    $Si\ Cx_1\ Ny_1\ Ht_1$, ou

    $Si\ Cx_1\ Ny_1\ Oz_1\ Ht_1$

    où

    $x_1 + y_1 + z_1 + t_1$ est compris entre 1,2 et 1,5 ;

    $t_1$ est compris entre 0,1 et 0,7, $x_1$ est faible au regard de $y_1$ et/ou $z_1$.

Par "$x_1$ faible", on entend que les propriétés physiques de la couche, et spécialement ses propriétés optiques, sont sensiblement indépendantes de l'incorporation de carbone.

Cette première couche est recouverte par une seconde couche transparente de dureté constituée de silicium, d'oxygène, d'azote, de carbone et d'hydrogène.

La composition de cette couche de dureté peut être dans les limites données dans le document FR-A-2.631.346 rappelées précédemment, mais est avantageusement dans les gammes suivantes :

    $SiC_{x_2}\ Ny_2\ Oz_2\ Ht_2$ avec

    $y_2$ compris entre 1,0 et 1,3,

    $t_2$ compris entre 0,1 et 0,7,

    $x_2$ et $z_2$ faibles devant $y_2$ ;

    $SiC_{x_2}\ Oz_2\ Ht_2$ avec

    $z_2$ compris entre 1,7 et 2,0,

    $t_2$ compris entre 0,1 et 0,7,

    $x_2$ faible devant $z_2$.

L'expérience montre que l'objectif est atteint par l'invention, dont le principe physique peut être expliqué de la façon suivante : l'absorption optique des alliages amorphes de silicium présente, à haute énergie, une croissance rapide (approximativement parabolique en fonction de l'énergie de photon hv). La limite de cette zone dite de forte absorption est voisine de la valeur de la bande interdite optique $E_g$ du matériau et dépend principalement de la composition chimique de ce dernier. Plus particulièrement, $E_g$ est uniquement fonction, au premier ordre, du nombre relatif de liaisons Si-Si dans le matériau, soit encore du paramètre $x_1 + y_1 + z_1 + t_1$. La valeur de ce paramètre peut être ajustée avec une grande souplesse dans un procédé d'élaboration par dépôt CVD assisté plasma, en jouant simplement sur les débits relatifs des différents gaz et sur les autres paramètres de préparation. On ajuste donc la valeur de $E_g$ de façon que le dépôt en film mince présente une transmission négligeable pour des longueurs d'onde inférieures à une valeur donnée, par exemple voisine de 350 nm dans le cas présent.

En pratique, la région spectrale de transition entre transparence et très forte absorption ($> 10^4$ $cm^{-1}$)

doit être rendue suffisamment étroite. En effet, les longueurs d'onde inférieures à 350 nm environ doivent être fortement absorbées, mais la couche doit rester sensiblement transparente pour les longueurs d'onde du visible immédiatement adjacentes dans le spectre (violet-bleu). Dans le cas contraire, une coloration jaune apparaît qui est absolument inacceptable pour la plupart des applications.

La fonction de transmission de la couche mince déposée sur un substrat transparent dépend non seulement du coefficient d'absorption, mais aussi de l'épaisseur de la couche, ainsi que des indices optiques du substrat et des autres couches transparentes constituant le revêtement protecteur.

En particulier, la transition entre quasi-transparence et transmission quasi-nulle est d'autant plus abrupte que l'épaisseur de la couche absorbante est élevée, mais cette épaisseur doit être évidemment limitée en pratique. La mise en oeuvre de l'invention est avantageusement faite de façon que l'épaisseur de la première couche anti-ultra-violet soit de l'ordre du micron, alors que l'épaisseur de la seconde couche transparente de dureté est de l'ordre de 2 à 4 microns. Avantageusement, on prévoit une couche d'accrochage entre substrat polycarbonaté et la première couche anti-ultra-violet, réalisée à partir de silane et de gaz plasmagène argon, selon le procédé décrit dans le document FR-A-2.631.346, et d'épaisseur 100 Angströms environ.

L'invention concerne donc également un procédé d'élaboration d'un revêtement multicouche, caractérisé en ce qu'on effectue successivement sur un support de polycarbonate, d'abord un pré-traitement par plasma, de préférence un plasma argon-ammoniac, puis on dépose une couche d'accrochage à partir de $SiH_4$, après quoi on procède au dépôt par plasma PECVD des première et seconde couches à partir de $SiH_4$, $O_2$ et/ou $N_2$, cette dernière le cas échéant avec un gaz vecteur de carbone.

On va maintenant décrire différents exemples de réalisation de mise en oeuvre de l'invention :

## Exemple 1 :

Une première méthode pour moduler la bande interdite optique consiste à réaliser par PECVD un oxyde hydrogéné faiblement carburé $SiCx_1Oz_1Ht_1$ avec $x < 2$, en fait $x_1 + z_1 + t_1$ compris entre 1,2 et 1,5, $t_1$ compris entre 0,1 et 0,7, $x_1$ faible au regard de $z_1$, de façon à diminuer la largeur de la bande interdite optique par rapport à celle du matériau stoechiométrique $SiO_2$ en créant des liaisons Si-Si. Cependant, ces oxydes sous-stoechiométriques présentent une faible dureté qui les rend impropres à assurer simultanément une fonction de protection mécanique. La couche anti-ultra-violet doit donc être recouverte d'une couche transparente dure. Expérimentalement, on constate qu'une épaisseur de 1 μm environ pour

la couche anti-ultra-violet est suffisante pour assurer une transition abrupte. L'augmentation de l'épaisseur totale de la structure reste donc dans des limites raisonnables, notamment vis-à-vis des problèmes de contraintes.

Le mode opératoire est le suivant :
- prétraitement par plasma $Ar/NH_3$ ;
- couche d'accrochage déposée à partir de $SiH_4$ selon la demande de brevet citée, d'épaisseur 100 Angströms environ ;
- couche anti-ultra-violet de $SiCx_1Oz_1Ht_1$ avec $x_1 + z_1 + t_1$ compris entre 1,2 et 1,5, $t_1$ compris entre 0,1 et 0,7, $x_1$ faible au regard de $z_1$, déposée à partir de $SiH_4$ et $O_2$ en plus du gaz plasmagène Ar, selon ce même procédé, d'épaisseur 1 micron environ ;
- couche dure selon le procédé cité, d'épaisseur 3 à 4 microns déposée à partir de $SiH_4$, $O_2$ et/ou $N_2$ et éventuellement d'un gaz vecteur de carbone.

## Exemple 2

La couche anti-ultra-violet peut également être réalisée avec un matériau nitrure de silicium hydrogéné, faiblement carburé, sous-stoechiométrique par rapport à $Si_3N_4$, soit $Si Cx_1 Ny_1 Oz_1 Ht_1$ avec $x_1 + y_1 + z_1 + t_1$ compris entre 1,2 et 1,5, $t_1$ compris entre 0,1 et 0,7, $x_1$ et $z_1$ faibles devant $y_1$.

Ce matériau est déposé à partir de $SiH_4$ et $N_2$.

L'expérience montre que ce type de matériau est particulièrement résistant aux tests accélérés de vieillissement sous très forte densité de rayonnement UV.

Le mode opératoire est similaire à l'exemple précédent.

## Exemple 3

Pour certaines applications, il peut être utile de moduler d'autres propriétés de la couche anti-ultra-violet, par exemple l'indice de réfraction dans la région de transparence, tout en maintenant sensiblement constante la valeur de la bande interdite optique $E_g$ (c'est-à-dire, en pratique, le seuil de coupure UV).

Pour cela, on peut faire varier les incorporations relatives d'azote et d'oxygène dans un oxynitrure de silicium hydrogéné, faiblement carburé, préparé à partir des trois gaz $SiH_4$, $O_2$ et $N_2$ selon le procédé cité, en utilisant différentes valeurs du rapport des débits gazeux $(O_2)/(N_2)$. On obtient ainsi un matériau de formule :

$SiCx_1 Ny_1 Oz_1 Ht_1$ avec $x_1 + y_1 + z_1 + t_1$ compris entre 1,2 et 1,5, $t_1$ compris entre 0,1 et 0,7, $x_1$ faible devant $y_1$ et/ou $z_1$.

Le mode opératoire est identique à l'exemple précédent.

A titre de comparaison, des échantillons des différents types décrits ci-dessus sont exposés au rayonnement d'une lampe UV de laboratoire, de puissance 5 W, émettant autour de 365 nm. Aucune altération visible n'est relevée après 3000 heures d'exposition en continu.

Les échantillons de polycarbonate revêtus du seul système couche d'adhérence + couche dure, sans couche anti-UV, présentent une délamination étendue du film protecteur après moins de 20 heures en moyenne.

L'invention s'applique à tous les domaines où une protection du polycarbonate contre un vieillissement occasionné par le rayonnement ultra-violet est nécessaire, en particulier pour les glaces de phares automobiles, les verres de lunettes.

L'invention n'est pas limitée aux modes de réalisations exemplifiés et est susceptible de modifications et de variantes qui apparaîtront à l'homme de l'art. Ainsi, selon les utilisations, on prévoira avantageusement, entre l'étape initiale de prétraitement plasma du substrat et l'étape de formation de la couche d'accrochage, une étape de dépôt plasma d'une sous-couche de silice d'épaisseur inférieure à 1 $\mu$m.

## Revendications

1.  Revêtement multicouche pour substrat polycarbonate utilisé à titre de succédané du verre, comportant essentiellement du silicium, du carbone, de l'azote, de l'oxygène et de l'hydrogène, caractérisé par une première couche anti-ultra-violet constituée de silicium, d'oxygène et/ou d'azote, de carbone et d'hydrogène, de formule :

    $$Si\ Cx_1\ Oz_1\ Ht_1$$
    $$Si\ Cx_1\ Ny_1\ Ht_1$$
    $$Si\ Cx_1\ Ny_1\ Oz_1\ Ht_1$$

    où, respectivement, $x_1 + z_1 + t_1$, $x_1 + y_1 + t_1$, $x_1 + y_1 + z_1 + t_1$ sont compris entre 1,2 et 1,5 de telle sorte que le seuil d'absorption optique du matériau soit centré autour de la limite inférieure des longueurs d'onde du spectre visible, soit environ 350 nm, et d'autre part :
    - $t_1$ compris entre 0,1 et 0,7 ;
    - $x_1$ faible devant $y_1$ et/ou $z_1$

    et par une seconde couche transparente de dureté constituée de silicium, d'oxygène, d'azote, de carbone et d'hydrogène de formule:

    $$SiCx_2\ Ny_2\ Oz_2\ Ht_2$$

    où

    $x_2$ est compris entre 0 et 5 ; $y_2$ est compris entre 0,3 et 0,8 ; $z_2$ est compris entre 1,3 et 2,5 ; $t_2$ est compris entre 0,5 et 1,2 et notamment

    $x_2$ est compris entre 0,3 et 1 ; $y_2$ entre 0,5 et 0,8 ; $z_2$ entre 1,3 et 2 ; $t_2$ entre 0,6 et 1.

2.  Revêtement multicouche comprenant une première couche anti-UV selon la revendication 1, et une seconde couche transparente de dureté constituée de silicium, de carbone, d'oxygène et d'hydrogène de formule :

    $SiCx_2Oz_2Ht_2$ avec $z_2$ compris entre 1,7 et 2,0 ; $t_2$ compris entre 0,1 et 0,7 ; $x_2$ faible devant $z_2$.

3.  Revêtement multicouche comprenant une première couche anti-UV selon la revendication 1, et une seconde couche transparente de dureté constituée de silicium, de carbone, d'azote, d'oxygène et d'hydrogène de formule :

    $SiCxNy_2\ Oz_2\ Ht_2$ avec $y_2$ compris entre 1,0 et 1,3 ; $t_2$ compris entre 0,1 et 0,7 ; $x_2$ et $z_2$ faible devant $y_2$.

4.  Revêtement multicouche selon l'une des revendications 1 à 3, caractérisé en ce que l'épaisseur de la première couche anti-ultra-violet est de l'ordre du micron.

5.  Revêtement multicouche selon la revendication 1, caractérisé en ce que l'épaisseur de la seconde couche transparente de dureté est de l'ordre de 2 à 4 microns.

6.  Revêtement multicouche selon l'une des revendications 1 à 5, caractérisé par une couche d'accrochage entre le substrat polycarbonaté et la première couche anti-ultra-violet de formule SiCxNyOzHt réalisée à partir de silane, d'une épaisseur de l'ordre de 100 Angstroms.

7.  Procédé d'élaboration d'un revêtement multicouche selon l'une quelconque des revendications 1 à 6, caractérisé en ce qu'on effectue successivement, sur un support de polycarbonate, d'abord un prétraitement par plasma, de préférence un plasma argon-ammoniac, puis on dépose une couche d'accrochage à partir de SiH$_4$, après quoi on procède au dépôt par plasma PECVD des première et seconde couches à partir de SiH$_4$, O$_2$ et/ou N$_2$, le cas échéant avec un gaz vecteur de carbone.

Office européen
des brevets

**RAPPORT DE RECHERCHE EUROPEENNE**

Numero de la demande

EP 91 40 1129

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-345 107 (L'AIR LIQUIDE)<br>* le document en entier * | 1-7 | C23C16/30<br>C23C16/02 |
| A,D | & FR-A-2 631 346 (L'AIR LIQUIDE)<br>--- | | |
| A | EP-A-289 402 (L'AIR LIQUIDE)<br>* le document en entier * | 1-7 | |
| A,D | & FR-A-2 614 317 (L'AIR LIQUIDE)<br>--- | | |
| A | US-A-4 568 614 (E. EICHEN ET AL)<br>--- | | |
| A | GB-A-2 185 626 (RCA CORPORATION)<br>--- | | |
| A | THIN SOLID FILMS<br>vol. 148, no. 3, 27 Avril 1987, LAUSANNE, CH<br>pages 285 - 291;<br>J.E. SCHOENHOLTZ ET AL: 'PLASMA-ENHANCED<br>DEPOSITION OF SILICON OXYNITRIDE FILMS '<br>----- | | |

| | DOMAINES TECHNIQUES RECHERCHES (Int. Cl.5) |
|---|---|
| | C23C |

Le présent rapport a été établi pour toutes les revendications

| Lieu de la recherche | Date d'achèvement de la recherche | Examinateur |
|---|---|---|
| LA HAYE | 24 JUILLET 1991 | JOFFREAU P. |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
........................................................................
& : membre de la même famille, document correspondant

EPO FORM 1503 03.82 (P0402)